# EUROPEAN PATENT SPECIFICATION

(11) **EP 0 412 838 B1**
(45) Date of publication and mention of the grant of the patent: **24.07.1996**
(21) Application number: 90308820.1
(22) Date of filing: 10.08.1990
(51) Int. Cl.: G06F 11/20

(54) **Semiconductor memories**
Halbleiterspeicher
Mémoires à semi-conducteur

(30) Priority: 11.08.1989 JP 208572/89
(43) Date of publication of application: 13.02.1991
(73) Proprietor: SONY CORPORATION, Tokyo 141 (JP)
(72) Inventor: Tani, Kazuhiko, c/o Patents Division, Shinagawa-ku, Tokyo 141 (JP)
(74) Representative: Cotter, Ivan John

(56) References cited:
- EP-A- 0 178 948
- EP-A- 0 300 467

## Description

This invention relates to semiconductor memories.

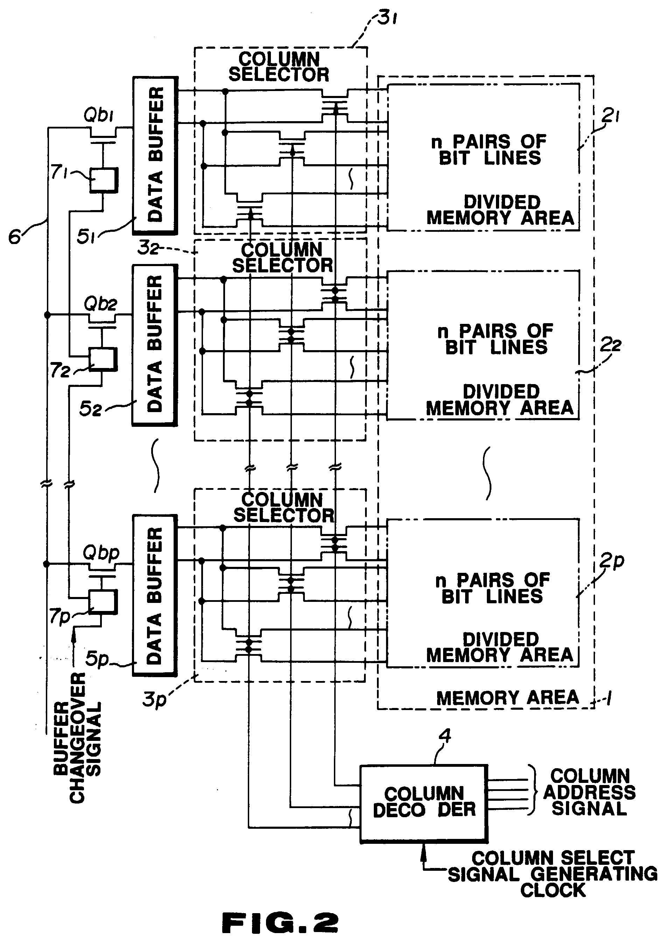

Figure 2 shows an example of a previously proposed ssemiconductor memory. As distinct from an ordinary random access memory (RAM) which may be accessed at random, this semiconductor memory is adapted to write or read signals in a predetermined sequence, and has been evolved as a video signal processing memory.

A memory area 1 has m pairs of column lines, m being a positive integer. The memory area 1 is divided into p divided memory areas 2₁, 2₂, ..., 2ₚ, p being equal to m/n, where n is a positive integer smaller than m. Each divided memory area 2 has n pairs of column lines. Column selectors 3₁, 3₂, ..., 3ₚ are respectively provided in association with the divided memory areas 2 for connecting a bit line pair of n pairs of bit lines of the divided memory areas 2 designated by the output of a column decoder 4. Data buffers 5₁, 5₂, ..., 5ₚ are provided in association with the divided memory areas 2, and are connected to the divided memory areas 2 corresponding thereto by way of the column selectors 3. Q_{b1}, Q_{b2}, ..., Q_{bp} are buffer changeover switching transistors connected between the data buffers 5 and a data bus 6, and are switched by driving circuits 7₁, 7₂, ..., 7ₚ. The driving circuits 7 are connected in tandem, and turn on the data buffers 5 for a certain time in a predetermined sequence. Thus they serve to sequentially connect the data buffers 5 to the data bus 6.

The operation is as follows. First explaining the reading operation, a pair of the lines of each divided memory area 2 is connected by an output signal of the column decoder 4 to the data buffer 5 via the column selector 3, and the signal stored in the memory cell is transferred to and stored in the data buffer 5. This operation is repeated sequentially until n signals are stored in the data buffer 5. The data buffer 5 connected to the data bus 6 by one driving circuit 7 supplies n signals sequentially. On termination of signal reading at one divided memory area 2, reading is performed at the next divided memory area 2. In this manner, reading is performed in all of the divided memory areas 2 in a predetermined sequence.

The writing operation will now be explained. Input data signals are supplied from the data bus 6 sequentially. These input data signals are sequentially fetched by one data buffer 5 selected by one driving circuit 7 and, when the number of bits of the signal reaches n, the input data signals are written via the column selector 3 into the divided memory area 2. After this operation has been repeated p times, data have been written in the memory cells connected to all of the bit lines.

The reason a data buffer 5 is not provided for each bit line pair, but one data buffer 5 is provided for each of a plurality of bit line pairs, is to avoid increase in the space required.

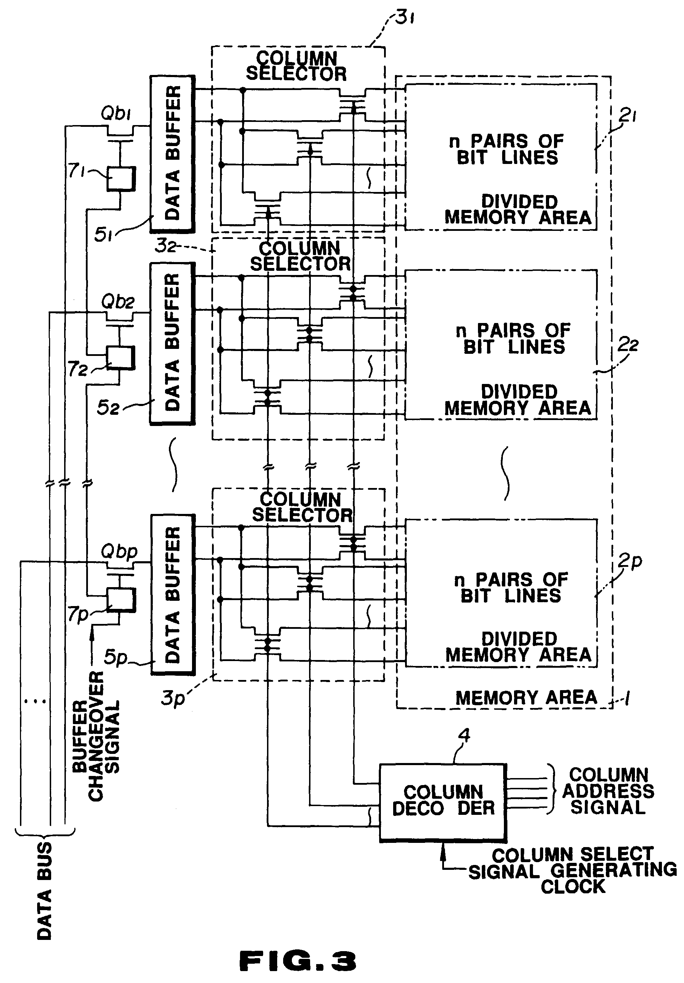

This semiconductor memory has one data bus 6. However, a plurality of data buses may also be provided. Figure 3 shows the provisions of q data buses.

Reading is performed by forming sequential data by repeating the operation of loading q data of n data signals on the data bus 6 in parallel and performing parallel series conversion n/q times.

For writing, input data signals supplied sequentially are converted into q parallel data which are simultaneously transferred to the data buffers 5. In this case, the drive circuits 7 turn on the buffer changeover switching transistors Q_{b} simultaneously.

After the transfer operations have been repeated n/q times, and when the n data signals are prepared at the data buffer 5, they are transferred via the column selectors 3 to the bit line pairs of the divided memory areas 2. This operation is repeated m/n times so that data can be written in the selected memory cells connecting to the column lines.

In a semiconductor memory of the type shown in Figures 2 and 3, when there is a defect in the memory cell, and a redundant memory area is provided as described in Japanese Patent Publication No. 63/29360, it is necessary to increase the memory area.

EP-A-0 300 467 discloses another example of a random access memory having a redundant memory area.

However, although the technology of Japanese Patent Publication No. 63/29360 is effective for an ordinary RAM, it cannot be applied to a semiconductor memory of the type in which the redundant memory is divided into a plurality of divided memory areas, data buffers are provided in association with the divided memory areas, and column selectors are interposed and accessed in a predetermined sequence by the intermediary of column selectors controlled by a column decoder between the divided memory area and the data buffer.

This is because the output line of the column decoder is supplied to a plurality of column selectors, so when switching to a redundant memory area due to a defect on a bit line, it is necessary that the signal of the defective bit line is not transferred to the data buffer. A method devised to achieve this is to inactivate that signal of the output signals of the column decoder which designates the column address including the defective bit. However, in such a case, the bit line pairs belonging to other divided memory areas are also inactivated if they correspond to the same column address.

It has also been contemplated to substitute the redundant memory area with all the bit line pairs selected by the output line of the column decoder selecting the defective bit line. However, in such a case, the area of the redundant memory area is substantially increased.

According to the present invention there is provided a semiconductor memory in which a normal memory area is divided into a plurality of divided memory areas:
a data buffer is provided for each of the divided memory areas;
the bit lines of each divided memory area are connected via a column selector to a data buffer corresponding to the divided memory area;
a buffer changeover switching means is connected between each data buffer and a data bus; and
column accessing is effected by controlling the buffer changeover switching means in a predetermined sequence while said column selector is controlled by output signals of a column decoder decoding the column address signals;
further comprising:
a redundant memory area;
a redundant data buffer;
redundancy select switching means connected between said redundant memory area and said redundant data buffer;
redundant data buffer changeover switching means connected between said redundant data buffer and said data bus;
bus separation switching means for separating portions corresponding to the normal memory at least during reading;
an address comparator circuit for storing the column address of a defective bit and turning said redundancy selecting switching means on when said address and said column address signal coincide with each other; and
a redundancy control circuit for turning on said redundant data buffer changeover switching means when said buffer changeover switching means connected to the data buffer corresponding to the divided memory area to which belongs the defective bit is on and the redundancy selecting switching means is on, said control circuit turning said bus separation switching means off, said buffer changeover switching means being controlled in a predetermined sequence while said column selector is controlled by output signals of the column decoder decoding the column address signals.

Thus an embodiment of semiconductor memory according to the present invention is characterized in that a redundant memory area and a redundant data buffer connected via redundancy select switching means are provided, the redundancy select switching means is turned on by an address comparator circuit when the defective column address coincides with the column address signal and, when the buffer switching means connected to the data buffer associated with the divided memory area where there is a defective bit is turned on and the redundancy select switching means is turned on, the redundant data buffer is connected to the data bus and, at least during reading, the regular memory area side is disconnected from the data bus.

With such a semiconductor memory, when the defective bit line is accessed, the redundant memory area is activated after the redundant data buffer has been connected to the data bus, while the regular memory area side is disconnected from the data bus, so that the defective bit line may be replaced by the redundant memory area. Thus the replacement by the redundant memory area of the defective bit may be performed without hindrance and without inactivating an output line selecting a defective bit line.

The invention will now be described by way of example with reference to the accompanying drawings, throughout which like parts are referred to by like references, and in which:
Figure 1 is a circuit block diagram of an embodiment of semiconductor memory according to the present invention; and
Figures 2 and 3 are circuit block diagrams of respective previously proposed semiconductor memories.

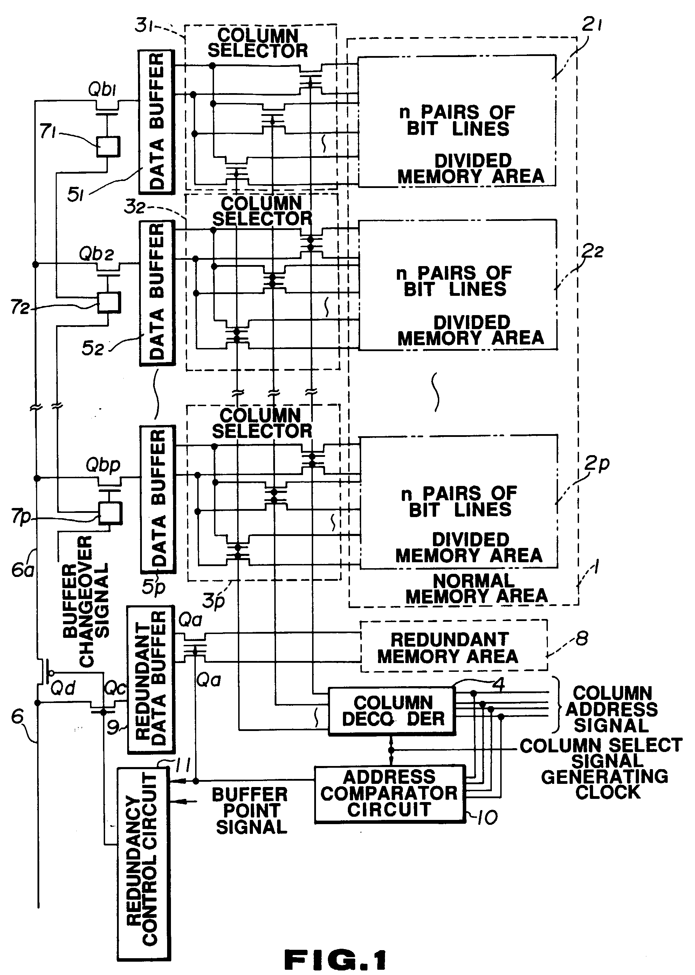

In the embodiment of Figure 1, a memory area has m pairs of column lines, m being a positive integer. The memory area 1 is divided into p divided memory areas 2₁, 2₂, ..., 2ₚ, p being equal to m/n, and n being a positive integer smaller than m. Each divided memory area 2 has n pairs of column lines.

Column selectors 3₁, 3₂, ..., 3ₚ are respectively provided in association with the divided memory areas 2 for connecting a bit line pair of n pairs of bit lines of the divided memory areas 2 designated by the output of a column decoder 4. Data buffers 5₁, 5₂, ..., 5ₚ are provided in association with the divided memory areas 2, and are connected to the respective divided memory areas 2 corresponding thereto by way of respective column selectors 3.

Buffer changeover switching transistors Q_{b1}, Q_{b2}, ..., Q_{bp} are connected between the data buffers 7₁, 7₂, ..., 7ₚ. The driving circuits 7 are connected in tandem and turn on the data buffers 5 for a certain time in a predetermined sequence. Thus they serve for sequentially connecting the data buffers 5 to the data bus 6.

A redundant memory area 8 is provided on bit line pair number one, and a redundant data buffer 9 is provided in association with the redundant memory area 8. A pair of redundancy select transistors Qₐ are connected between the bit line pair of the redundant memory area 8 and the redundant data buffer 9.

A redundant data buffer switching transistor Q_{c} is connected between the redundant data buffer 9 and the data bus 6, and a bus separation transistor Q_{d} separates the normal memory area side portion 6ₐ of the data bus 6 from the proximal side of the data bus 6 when turned off. Qₐ to Q_{c} are n-channel MOS transistors, whereas Q_{d} is a p-channel MOS transistor.

An address comparator 10 comprises memory means for storing column addresses of the defective bit and comparator means for comparing the column address of the defective bit and the column address signal supplied to the column decoder 4. A coincidence signal is produced as a result of this comparison, and is supplied as a control signal to the redundancy select transistors Qₐ to turn them off.

A redundancy control circuit 11 receives a buffer point signal indicating which buffer changeover switching transistor Q_{b} connected to the data buffer 5 is on, and an output signal of the address comparator 10, to control the redundant data buffer switching transistor Q_{c} and the bus separation transistor Q_{d}. More specifically, it supplies a driving signal when the buffer changeover switching transistor Q_{b} connected to the data buffer 5 associated with the split memory area of the defective bit is on and the coincidence output is being supplied from the address comparator 10 to turn the normally off redundant data buffer switching transistor Q_{c} on, while turning the normally on bus separation transistor Q_{d} off.

The operation will now be explained. The bus separation transistor Q_{d} is normally on, and the redundant data buffer switching transistor Q_{c} is off, and the operation is not basically changed from that of the semiconductor memory of Figure 2. That is, the operation when the normal bit in the regular memory area 1 is accessed is not basically different.

Explaining first the normal reading operation, a pair of the lines of each divided memory area 2 is connected by an output signal of the column decoder 4 to a data buffer 5 via a column selector 3, and the signal stored in the memory cell is transferred to and stored in the data buffer 5. The column address signal is switched and the output signal of the column decoder 4 is switched therewith so that the signal from the next bit line pair is transferred to and stored in the data buffer 5. This operation is repeated sequentially until n signals are stored in the data buffer 5. The data buffer 5 connected to the data bus 6 by one driving circuit 7 supplies n signals sequentially. On termination of signal reading at one divided memory area 2, reading is performed at the next divided memory area 2. In this manner, reading is performed in all of the divided memory areas 2 in a predetermined sequence.

The normal writing operation is as follows. Input data signals are supplied from the data bus 6 sequentially. These input data signals are sequentially fetched by one data buffer 5 selected by one driving circuit 7 and, when the number of bits of the signal reaches n, the input data signals are written via the column selector 3 into the divided memory area 2. After this operation has been repeated p times, data have been written in the memory cells connected to all of the bit lines.

The operation when a malfunctioning (defective) bit is accessed, that is when the redundant memory area is to come into operation, will now be explained.

When the defective bit is accessed, a coincidence signal is supplied from the address comparator circuit 10. This is because the column address signal supplied to the column decoder 4 and the column address of the defective bit necessarily coincide when the defective bit is accessed. By this coincidence signal, the redundancy select transistors Qₐ are turned on.

A driving signal is supplied from the redundancy control circuit 11 when the defective bit is accessed. It is because the redundancy control circuit 11 is at a position to determine by the buffer point signal if the buffer changeover switching transistor Q_{b} connected to the data buffer 3 corresponding to the split memory area 2 associated with the defective bit is on, and has the function of supplying an output signal when the coincidence signal is produced from the address comparator circuit 10 when the buffer changeover switching transistor Q_{b} is on. It is by this driving signal that the redundant data buffer switching transistor Q_{c} is turned on and the bus separation transistor Q_{d} is turned off.

As a result, the redundant memory area 8 is connected via the redundancy select transistors Qₐ to the redundant data buffer 9, while the redundant data buffer 9 and the data bus 6 are connected via the redundant data buffer switching transistor Q_{c} so that reading can be effected from the redundant memory area 8 or writing can be effected into the redundant memory area 8. Since the portion 6a of the regular memory area side of the data bus 6 is segregated from the proximal side of the data bus 6 by the bus separation transistor Q_{d} which is turned off, the situation of simultaneous operation of the defective bit and the redundant memory area 8 can be avoided. This avoidance is crucial when reading signals, since otherwise the signal from the defective bit and the redundant memory area may be mixed together.

It is however not always necessary to turn off the bus separation transistor Q_{d} when writing data signals. This is because, even if the data signals are written into both the redundant memory area 8 and the defective bit, the defective bit can be compensated without any hindrance if reading is made only from the redundant memory area 8 during reading.

Although only one data bus 6 is used in the semiconductor memory of the present embodiment, the invention may be applied to the case of a plurality of data buses 6. In this case, the number of redundant memory areas 8, redundant data buffers 9, address comparator circuits 10, redundancy control circuits 11, redundancy select transistors Qₐ, redundant data buffer switching transistors Q_{c}, and bus separation transistors Q_{d} of the redundancy circuit equal the number of data buses 6.

## Claims

1. A semiconductor memory in which a normal memory area (1) is divided into a plurality of divided memory areas (2);
a data buffer (5) is provided for each of the divided memory areas (2);
the bit lines of each divided memory area (2) are connected via a column selector (3) to a data buffer (5) corresponding to the divided memory area (2);
a buffer changeover switching means (Q_{b}) is connected between each data buffer (5) and a data bus (6); and
column accessing is effected by controlling the buffer changeover switching means (Q_{b}) in a predetermined sequence while said column selector (3) is controlled by output signals of a column decoder (4) decoding the column address signals;
further comprising:
a redundant memory area (8);
a redundant data buffer (9);
redundancy select switching means (Qₐ) connected between said redundant memory area (8) and said redundant data buffer (9);
redundant data buffer changeover switching means (Q_{c}) connected between said redundant data buffer (9) and said data bus (6);
bus separation switching means (Q_{d}) for separating portions corresponding to the normal memory at least during reading;
an address comparator circuit (10) for storing the column address of a defective bit and turning said redundancy select switching means (Q_{c}) on when said address and said column address signal coincide with each other; and
a redundancy control circuit (11) for turning on said redundant data buffer changeover switching means (Q_{c}) when said buffer changeover switching means (Q_{b}) connected to the data buffer (5) corresponding to the divided memory area to which belongs the defective bit is on and the redundancy select switching means (Qₐ) is on, said control circuit (11) turning said bus separation switching means (Q_{d}) off, said buffer changeover switching means (Q_{b}) being controlled in a predetermined sequence while said column selector (3) is controlled by output signals of the column decoder (4) decoding the column address signals.

2. A memory according to claim 1 wherein each data buffer (5) is connected to one data bus (6).

3. A memory according to claim 1 wherein a common signal is supplied to the redundant data buffer changeover switching means (Q_{c}) and the bus separation switching means (Q_{d}) by the redundancy control circuit (11), and these switching means (Q_{c}, Q_{d}) are MOS transistors having opposite conductivity type channels.

## Patentansprüche

1. Halbleiterspeicher, bei dem ein Normalspeicherbereich (1) in mehrere separate Speicherbereiche (2) aufgeteilt ist;
ein Datenpuffer (5) für jeden der separaten Speicherbereiche (2) vorgesehen ist;
die Bitleitungen jedes separaten Speicherbereiches (2) über eine Spaltenauswahlschaltung (3) mit einem dem separaten Speicherbereich (2) entsprechenden Datenpuffer (5) verbunden sind;
eine Pufferumschalteeinrichtung (Q_{b}) zwischen jedem Datenpuffer (5) und einem Datenbus (6) zwischengeschaltet ist; und
ein Spaltenzugriff durch Steuerung der Pufferumschalteeinrichtung (Q_{b}) in einer festgelegten Reihenfolge ausgeführt wird, während die Spaltenauswahleinrichtung (3) durch Ausgangssignale eines Spaltendecoders (4) gesteuert wird, der die Spaltenadressignale decodiert;
ferner aufweisend:
einen Redundanzspeicherbereich (8);
einen Redundanzdatenpuffer (9);
eine Redundanzauswahlschalteinrichtung (Qₐ), die zwischen dem Redundanzspeicherbereich (8) und dem Redundanzdatenpuffer (9) zwischengeschaltet ist;
eine Redundanzdatenpuffer-Umschalteinrichtung (Q_{c}), die zwischen dem Redundanzdatenpuffer (9) und dem Datenbus (6) zwischengeschaltet ist;
eine Bustrennschalteinrichtung (Q_{d}) zur Trennung von Abschnitten entsprechend dem normalen Speicher wenigstens während des Auslesens;
eine Adresskomparatorschaltung (10) zur Speicherung der Spaltenadresse eines defekten Bits und zum Einschalten der Redundanzauswahl-Schalteinrichtung (Q_{c}), wenn die Adresse und das Spaltenadressignal miteinander übereinstimmen; und
eine Redundanzsteuerschaltung (11) zum Einschalten der Redundanzdatenpuffer-Umschalteinrichtung (Q_{c}), wenn die mit dem Datenpuffer (5) entsprechend dem separaten Speicherbereich, zu dem das defekte Bit gehört, verbundene Pufferumschalteinrichtung (Q_{b}) eingeschaltet ist und die Redundanzauswahl-Schalteinrichtung (Qₐ) eingeschaltet ist, wobei die Steuerschaltung (11) die Bustrennschalteinrichtung (Q_{d}) ausschaltet, wobei die Pufferumschalteinrichtung (Q_{b}) in einer festgelegten Reihenfolge gesteuert wird, während die Spaltenauswahleinrichtung (3) durch Ausgangssignale von dem Spaltendecoder (4), gesteuert wird, der die Spaltenadressignale decodiert.

2. Speicher gemäß Anspruch 1,
wobei jeder Datenpuffer (5) mit einem Datenbus (6) verbunden ist.

3. Speicher gemäß Anspruch 1,
wobei ein gemeinsames Signal der Redundanzdatenpuffer-Umschalteinrichtung (Q_{c}) und der Bustrennschalteinrichtung (Q_{d}) von der Redundanzsteuerschaltung (11) zugeführt wird und diese Schalteinrichtungen (Q_{c}, Q_{d}) MOS-Transistoren mit entgegengesetzten Kanalleitfähigkeitstypen sind.

## Revendications

1. Mémoire à semiconducteur, dans laquelle:
- une zone de mémoire normale (1) est divisée en une pluralité de zones de mémoire divisée (2);
- une mémoire tampon de données (5) est prévue pour chacune des zones de mémoire divisée (2);
- les lignes de binaires de chacune des zones de mémoire divisée (2) sont connectées, par l'intermédiaire d'un sélecteur de colonne (3), à une mémoire tampon de données (5) correspondant à la zone de mémoire divisée (2);
- des moyens de commutation de changement de mémoire tampon (Qb) sont connectés entre chaque mémoire tampon de données (5) et un bus de données (6); et
- l'accès aux colonnes est effectué en commandant les moyens de commutation de changement de mémoire tampon (Qb) dans un ordre prédéterminé pendant que ledit sélecteur de colonne (3) est commandé par des signaux de sortie d'un décodeur de colonnes (4) décodant les signaux d'adresses de colonnes,
la mémoire comprenant en outre:
- une zone de mémoire redondante (8);
- une mémoire tampon de données redondante (9);
- des moyens de commutation de sélection de redondance (Qa) montés entre ladite zone de mémoire redondante (8) et ladite mémoire tampon de données redondante (9);
- des moyens de commutation de changement de mémoire tampon de données redondante (Qc) montés entre ladite mémoire tampon de données redondante (9) et ledit bus de données (6);
- des moyens de commutation de séparation de bus (Qd) pour séparer des parties correspondant à la mémoire normale au moins pendant la lecture;
- un circuit comparateur d'adresses (10) pour mémoriser l'adresse de la colonne d'un binaire défectueux et rendre conducteurs lesdits moyens de commutation de sélection de redondance (Qc) lorsque ladite adresse et ledit signal d'adresse de colonne coïncident l'un avec l'autre; et
- un circuit de commande de redondance (11) pour rendre conducteur lesdits moyens de commutation de changement de mémoire tampon de données redondante (Qc) lorsque lesdits moyens de commutation de changement de mémoire tampon (Qb) connectés à la mémoire tampon de données (5) correspondant à la zone de mémoire divisée à laquelle appartient le binaire défectueux sont conducteurs et que les moyens de commutation de sélection de redondance (Qa) sont conducteurs, ledit circuit de commande de redondance (11) rendant non conducteurs lesdits moyens de commutation de séparation de bus (Qd), lesdits moyens de commutation de changement de mémoire tampon (Qb) étant commandés dans un ordre prédéterminé pendant que ledit sélecteur de colonne (3) est commandé par des signaux de sortie du décodeur de colonnes (4) décodant les signaux d'adresses de colonnes.

2. Mémoire selon la revendication 1, dans laquelle chaque mémoire tampon de données (5) est connectée à un bus de données (6).

3. Mémoire selon la revendication 1, dans laquelle un signal commun est appliqué aux moyens de commutation de changement de mémoire tampon de données redondante (Qc) et aux moyens de commutation de séparation de bus (Qd) par le circuit de commande de redondance (11), et ces moyens de commutation (Qc, Qd) sont des transistors MOS ayant des canaux de types de conductibilité opposés.
